# EUROPEAN PATENT APPLICATION

(11) **EP 4 664 765 A1**
(43) Date of publication of application: **17.12.2025**
(21) Application number: 24753098.3
(22) Date of filing: 22.01.2024
(51) Int. Cl.: H03M 7/30, H03M 7/40

(54) **DECODING DEVICE AND METHOD, AND ENCODING DEVICE AND METHOD**

(30) Priority: 10.02.2023 JP 2023019384
(71) Applicant: Sony Group Corporation, Tokyo 108-0075 (JP)
(72) Inventor: NISHIGORI Shuichiro, Tokyo 108-0075 (JP); TAKEDA Hirofumi, Tokyo 108-0075 (JP)
(74) Representative: 2SPL Patentanwälte PartG mbB
(86) International application number: PCT/JP2024/001559
(87) International publication number: WO 2024/166652

(57) **Abstract**

The present technology relates to a decoding device, a decoding method, a coding device, and a coding method capable of efficiently coding or decoding multiplexed data.

The decoding device acquires multiplexed configuration data indicating a multiplexed configuration of different types of data, decodes multiplexed coded data obtained by coding multiplexed data obtained by multiplexing the different types of data on the basis of the multiplexed configuration data, to obtain the multiplexed data, and demultiplexes the multiplexed data on the basis of the multiplexed configuration data. The present technology is applicable to a data communication system for haptic data.

## Description

### [Technical Field]

The present technology relates to a decoding device, a decoding method, a coding device, and a coding method, and particularly to a decoding device, a decoding method, a coding device, and a coding method capable of efficiently coding or decoding multiplexed data.

### [Background Art]

In recent years, a technology for haptic reproduction (haptics) has started being widely used. In a consumer game industry, for example, vibration presentation (haptic feedback) from a vibration presentation device (e.g., voice coil type) equipped within a controller is employed to express collisions, shocks, feelings, and the like produced during a game, and force sense presentation (force feedback) from an actuator equipped within a controller is employed to express hardness of a gun trigger and the like during a game.

Moreover, such a product which uses a warm-cold sense presentation device, such as a Peltier element, for the purpose of body heating and cooling is widely used.

For presenting the foregoing haptic senses such as "vibration," "force," and "temperature," time-series haptic data needs to be transferred.

Haptic data to be used may be data actually measured by various types of sensors such as a vibration sensor, an acceleration sensor, a pressure sensor, and a temperature sensor, or may be any data created by a creator.

In actual situations, haptic data is usually coded to reduce the size of the data before recording or transfer at the time of use of haptic presentation for various applications.

The haptic data associated with "vibration" herein has signals in a frequency band ranging from dozens of hertz to one kilohertz as main constituent elements, and therefore has a relatively high frequency. Accordingly, for the haptic data associated with "vibration," there is adopted coding, particularly, highly efficient lossy coding, which is similar to coding of audio signals as one-dimensional signals which are the same as signals of this haptic data.

Meanwhile, haptic data associated with "force" and "temperature" requires a device dedicated for presentation of haptic senses. Accordingly, for haptic data associated with "force" and "temperature," lossless coding is adopted so as to transfer multiple control parameters necessary for driving this device with an update frequency approximately in a range shorter than dozens of hertz without losses.

For example, PTL 1 describes a technology which combines linear prediction with differential coding, which is one example of lossless coding, for handling audio signals.

### [Citation List]

### [Patent Literature]

[PTL 1]
Japanese Patent Laid-Open No. 2004-266587

### [Summary]

### [Technical Problem]

Meanwhile, haptic senses are distributed throughout a human body. It is therefore considered that a large number of portions of the body are designated as targets of haptic presentation. In a case where a large number of haptic presentation portions are designated, i.e., a large number of channels of haptic data are provided, a data volume may increase according to an increase in coded data of the large number of channels if conventional differential coding is only applied individually.

The present technology has been developed in consideration of the above-mentioned circumstances, and achieves highly efficient coding or decoding of multiplexed data.

### [Solution to Problem]

A decoding device according to one aspect of the present technology includes an acquisition unit that acquires multiplexed configuration data indicating a multiplexed configuration of different types of data, a data decoding unit that decodes multiplexed coded data obtained by coding multiplexed data obtained by multiplexing the different types of data on the basis of the multiplexed configuration data, to obtain the multiplexed data, and a demultiplexing unit that demultiplexes the multiplexed data on the basis of the multiplexed configuration data.

A coding device according to a different aspect of the present technology includes a data coding unit that codes multiplexed data obtained by multiplexing different types of data on the basis of multiplexed configuration data indicating a multiplexed configuration of the different types of data to generate multiplexed coded data, and an output unit that outputs the multiplexed configuration data and the multiplexed coded data to an outside.

According to the one aspect of the present technology, multiplexed configuration data indicating a multiplexed configuration of different types of data is acquired. Multiplexed coded data obtained by coding multiplexed data obtained by multiplexing the different types of data on the basis of the multiplexed configuration data is decoded to obtain the multiplexed data. Thereafter, the multiplexed data is demultiplexed on the basis of the multiplexed configuration data.

According to the different aspect of the present technology, multiplexed data obtained by multiplexing different types of data on the basis of multiplexed configuration data indicating a multiplexed configuration of the different types of data is coded to generate multiplexed coded data. The multiplexed configuration data and the multiplexed coded data are output to an outside.

### [Brief Description of Drawings]

[FIG. 1]

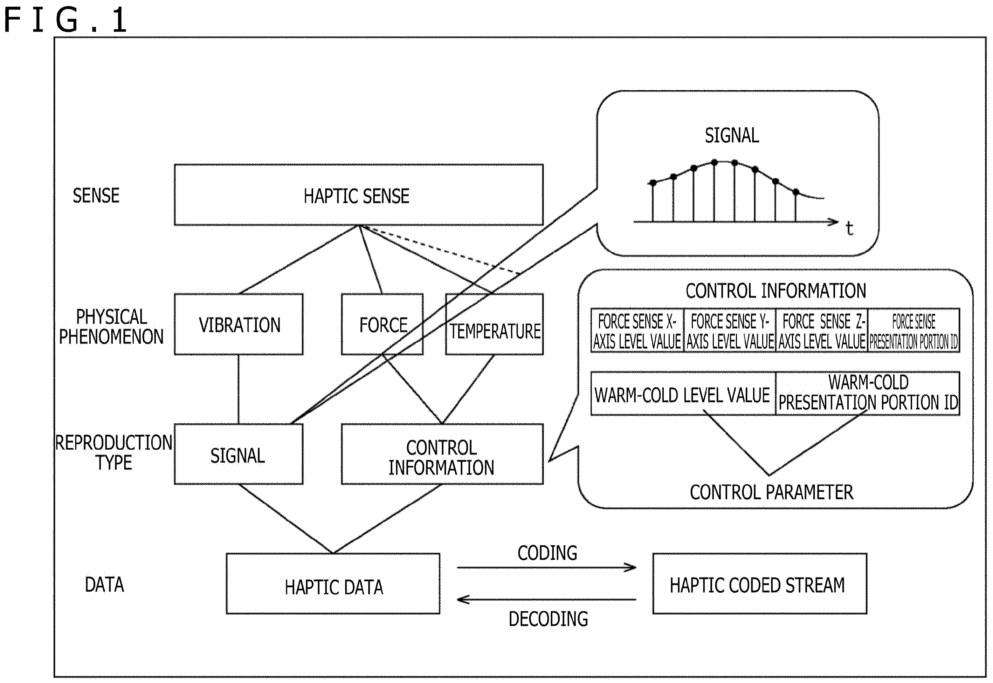

   FIG. 1 is a diagram for explaining an outline of the present technology.
[FIG. 2]

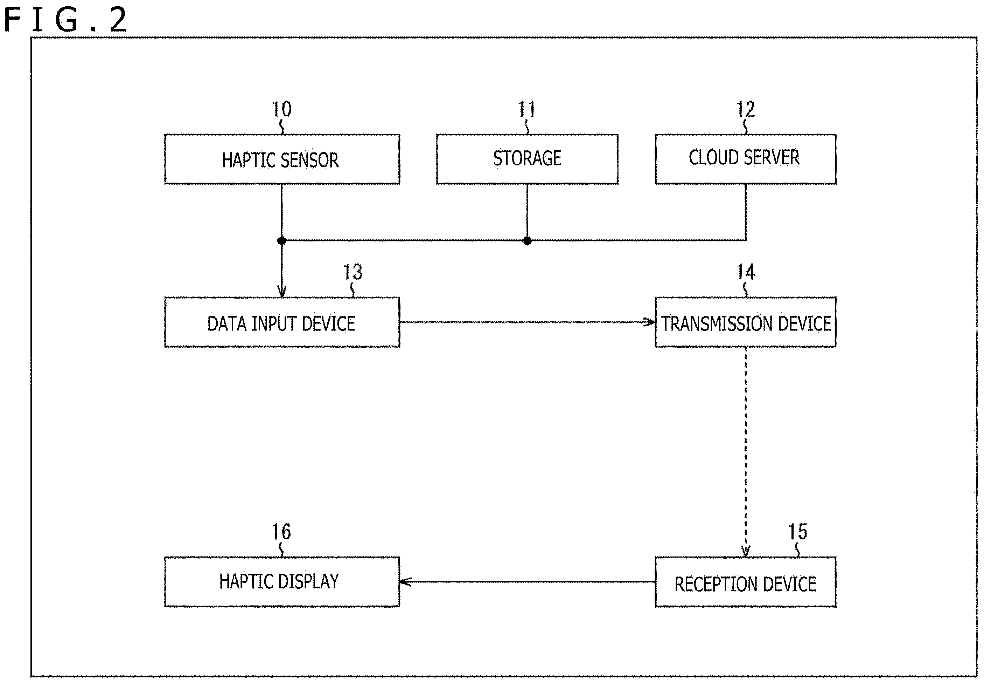

   FIG. 2 is a block diagram illustrating a configuration example of a data communication system according to an embodiment of the present technology.
[FIG. 3]

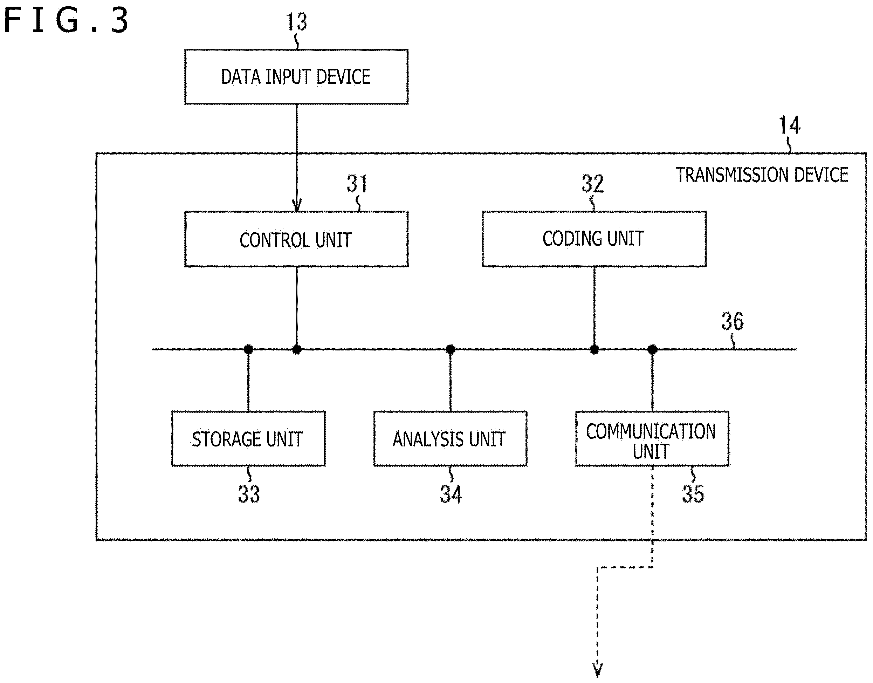

   FIG. 3 is a block diagram illustrating a configuration example of a transmission device in FIG. 2.
[FIG. 4]

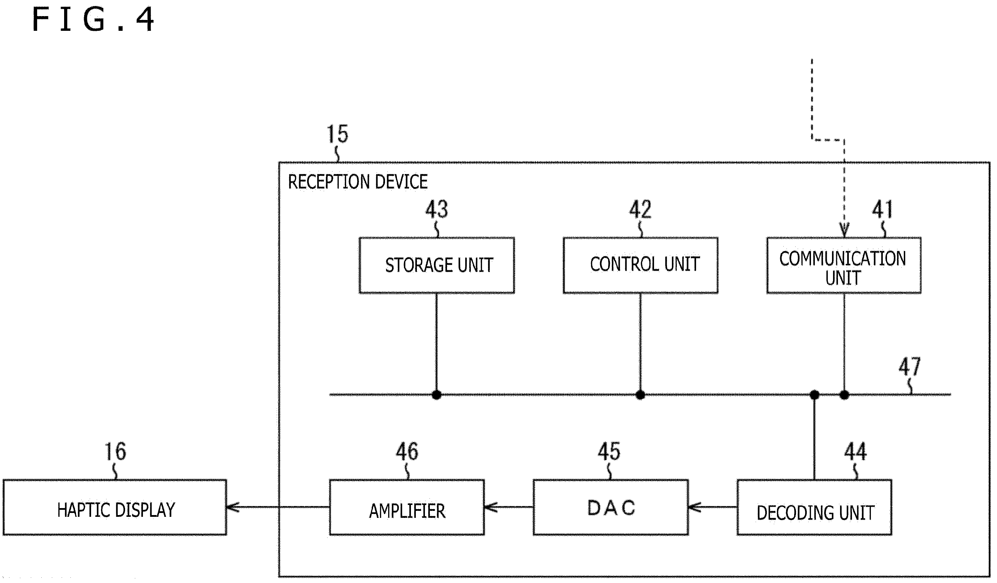

   FIG. 4 is a block diagram illustrating a configuration example of a reception device in FIG. 2.
[FIG. 5]

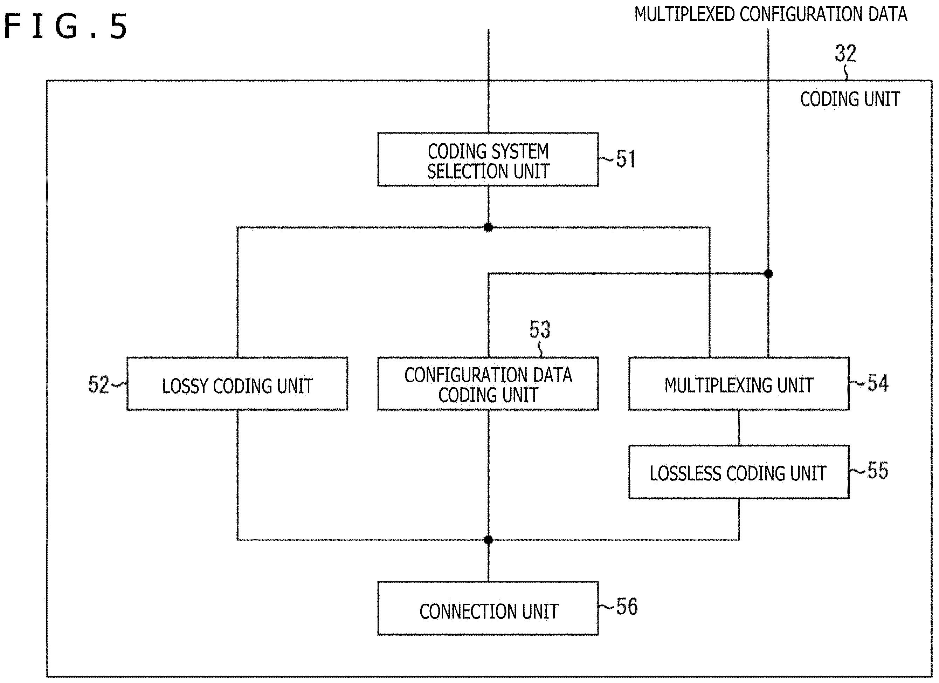

   FIG. 5 is a block diagram illustrating a configuration example of a coding unit in FIG. 3.
[FIG. 6]

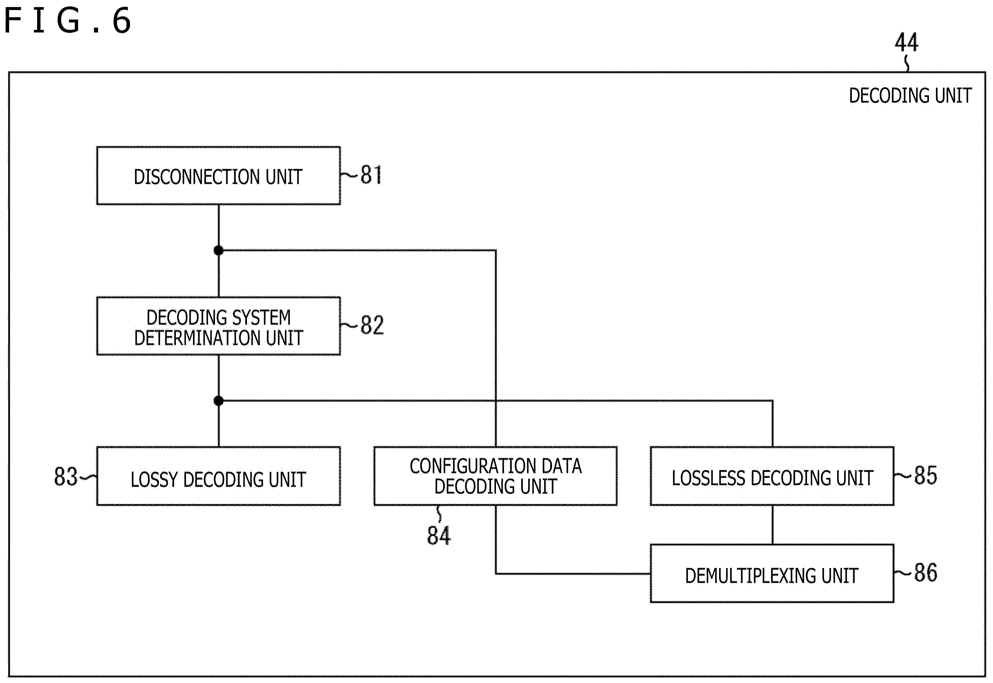

   FIG. 6 is a block diagram illustrating a configuration of a decoding unit in FIG. 4.
[FIG. 7]

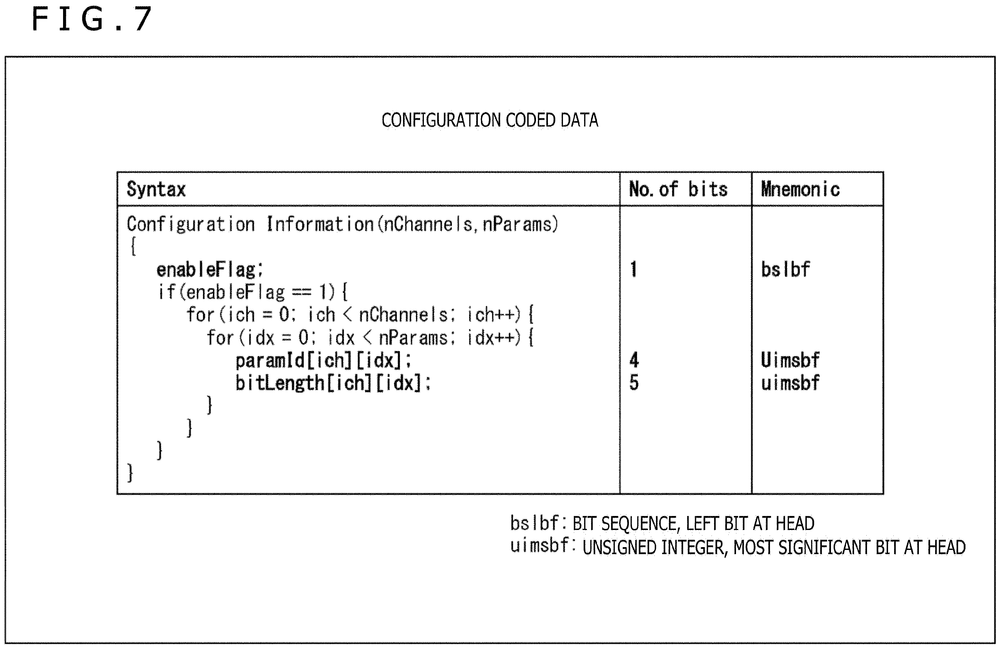

   FIG. 7 is a diagram illustrating a format example of configuration coded data.
[FIG. 8]

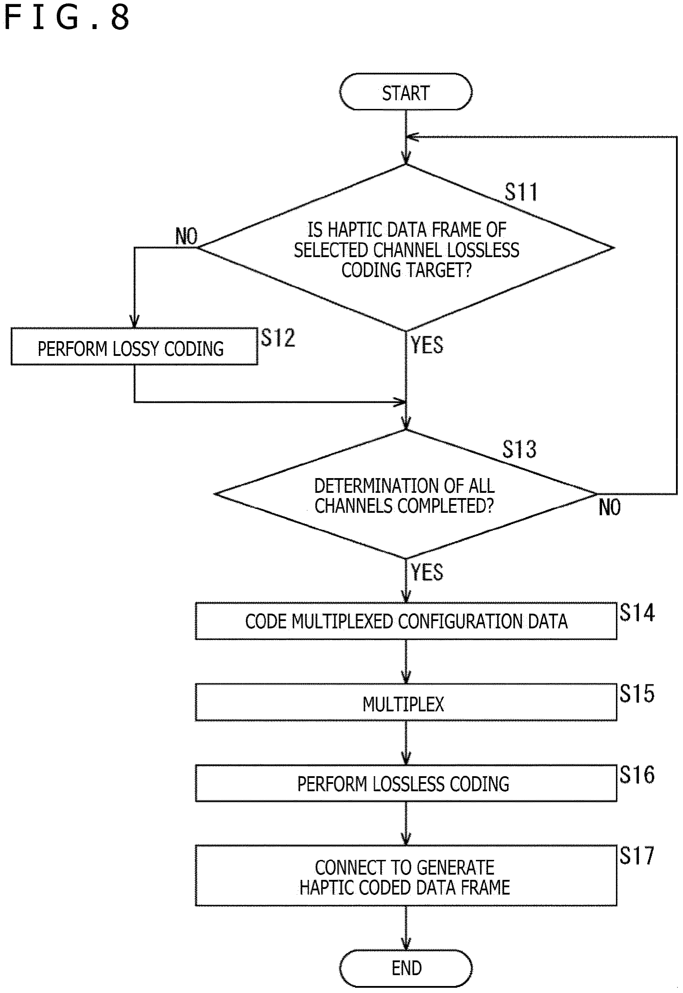

   FIG. 8 is a flowchart illustrating a process performed by the coding unit in FIG. 5.
[FIG. 9]

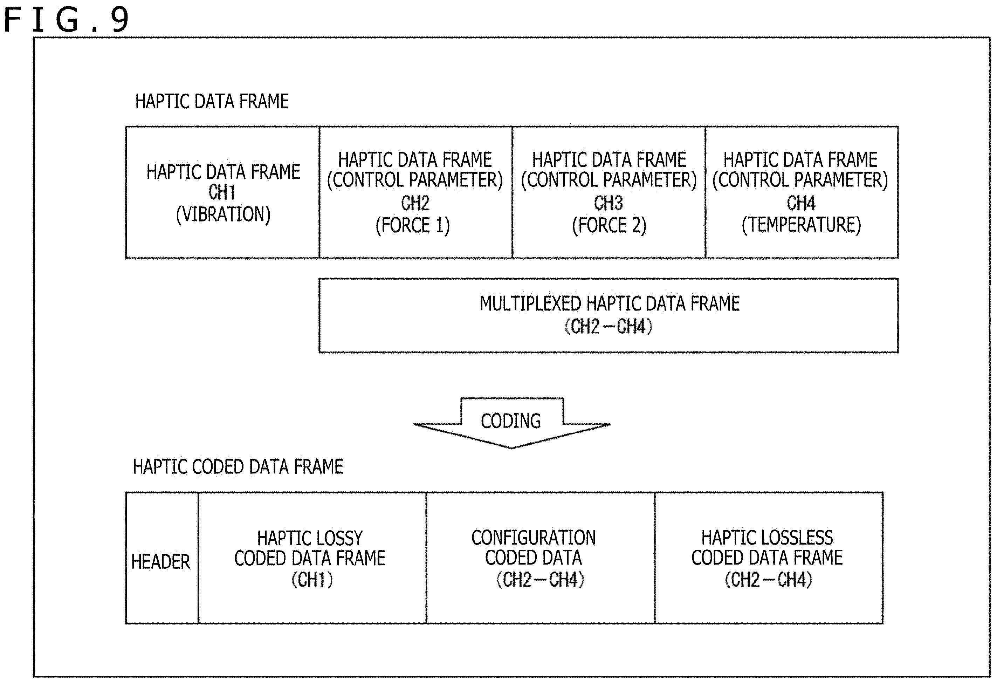

   FIG. 9 is a diagram illustrating a concept of a configuration example of a data frame.
[FIG. 10]

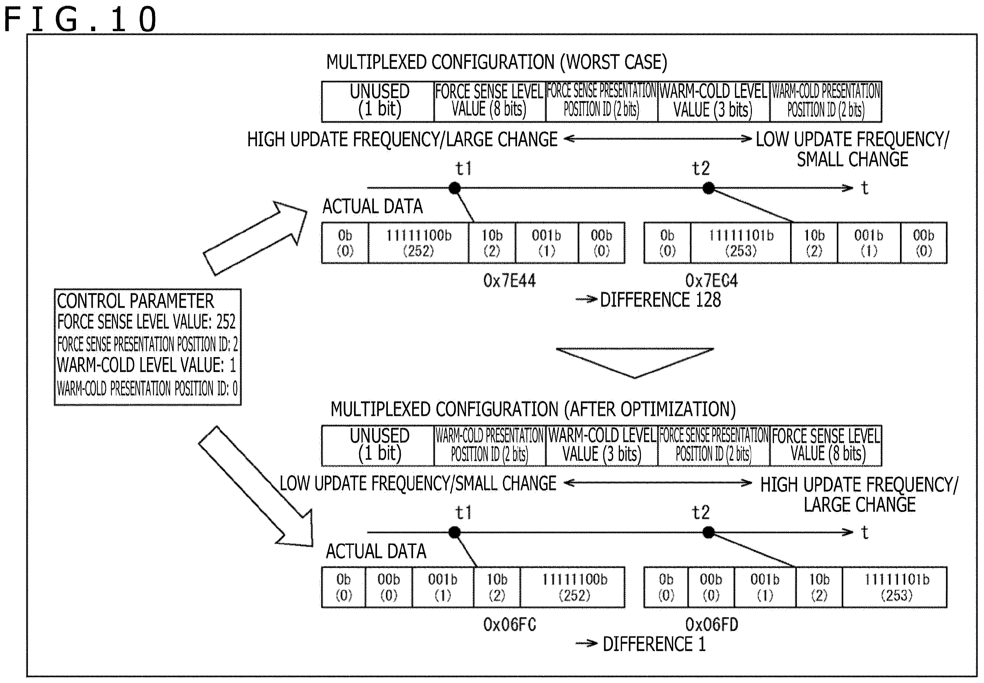

   FIG. 10 is a diagram illustrating an example of a multiplexed configuration.
[FIG. 11]

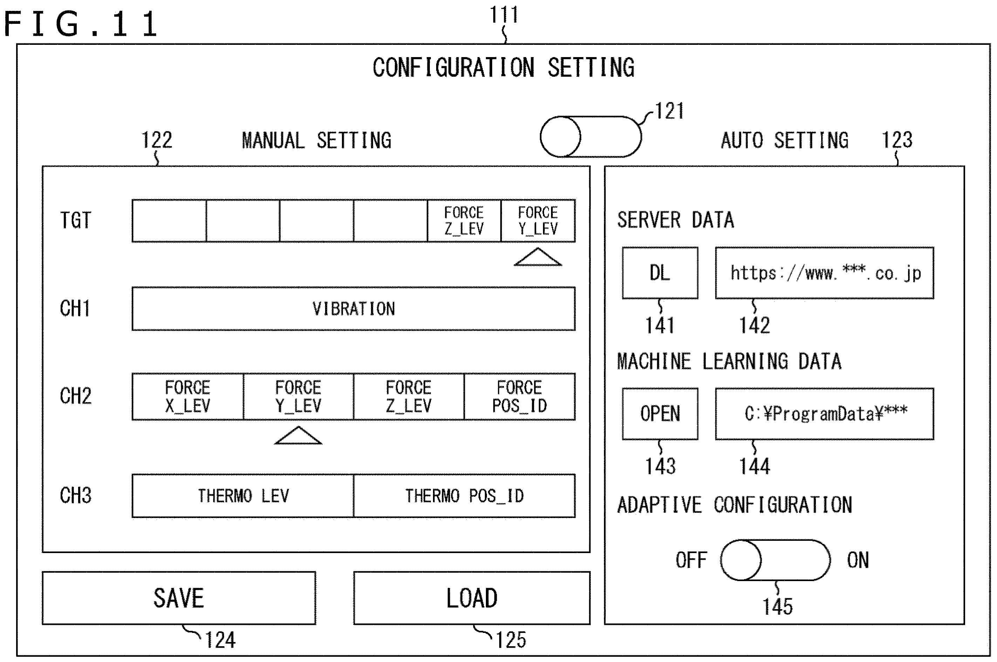

   FIG. 11 is a diagram illustrating a screen example of a GUI application.
[FIG. 12]

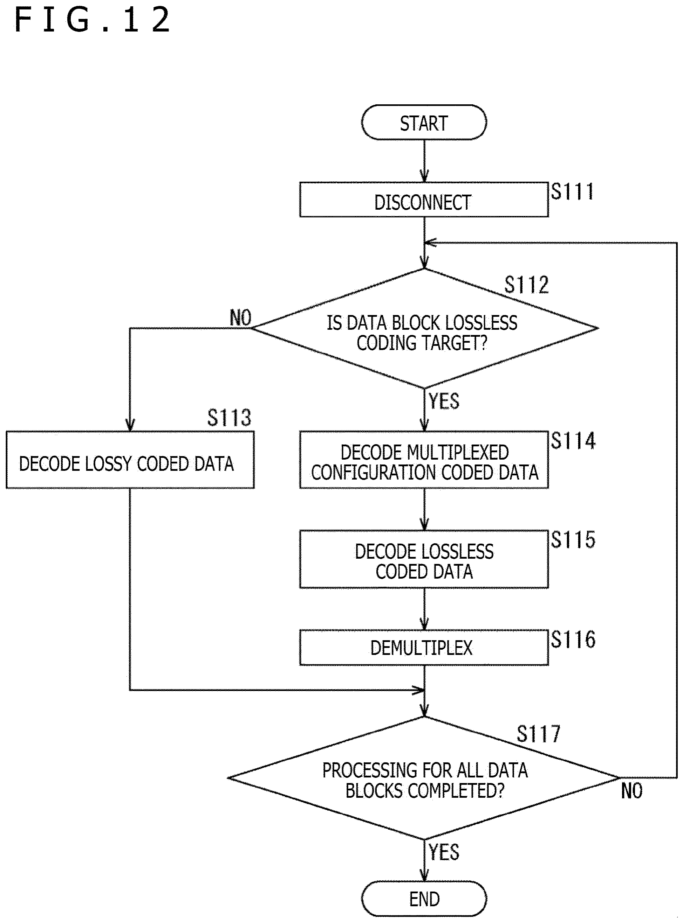

   FIG. 12 is a flowchart illustrating a process performed by the decoding unit in FIG. 6.
[FIG. 13]

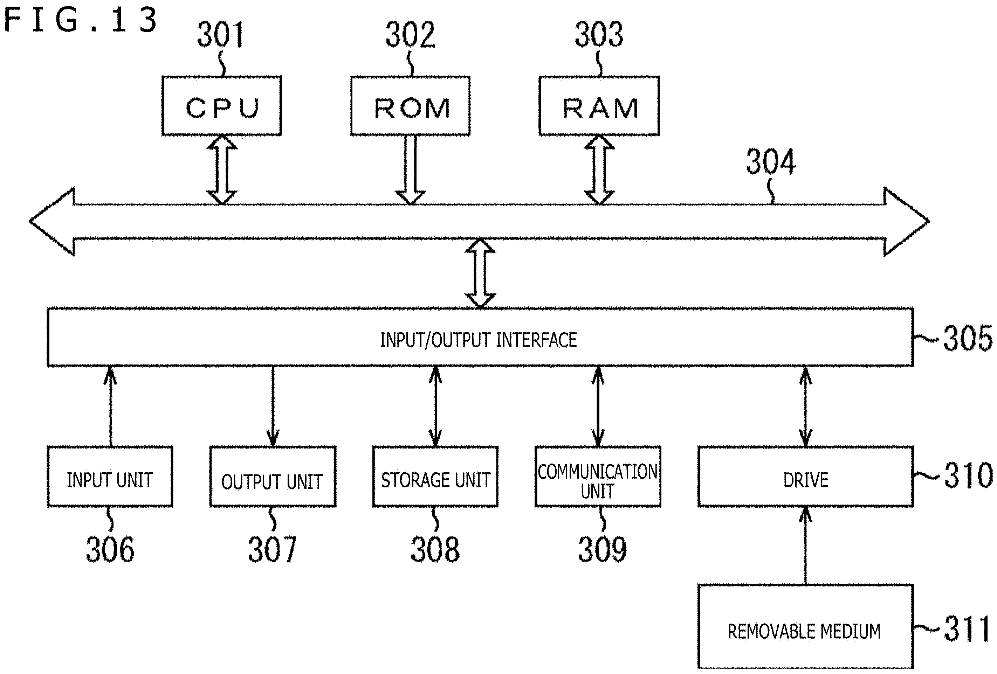

   FIG. 13 is a block diagram illustrating a configuration example of a computer.

### [Description of Embodiment]

An embodiment for carrying out the present technology will hereinafter be described. Description will be presented in the following order.
1. Conventional technology and outline of present technology
2. Configurations
3. Details
4. Others

### <1. Conventional technology and outline of present technology>

### <Outline>

FIG. 1 is a diagram for explaining an outline of the present technology.

A technology for haptic reproduction (haptics), which is a technology for reproducing haptic senses included in human senses, has started being widely used. For presenting physical phenomena, such as "vibration," "force," and "temperature," included in haptic senses in haptics, time-series haptic data needs to be transferred.

Haptic data to be used may be data actually measured by various types of sensors such as a vibration sensor, an acceleration sensor, a pressure sensor, and a temperature sensor, or may be any data created by a creator.

In actual situations, haptic data is usually coded to reduce the size of the data before recording or transfer at the time of use of haptic presentation for various applications.

The haptic data associated with "vibration" herein has, as main constituent elements, signals which are continuous with time as indicated in a graph in a right part of the figure and are in a frequency band ranging from dozens of hertz to one kilohertz, and therefore has a relatively high frequency.

Accordingly, for the haptic data associated with "vibration," there is adopted coding, particularly, highly efficient lossy coding, which is similar to coding of audio signals as one-dimensional signals which are the same as signals of this haptic data.

Meanwhile, haptic data associated with "force" and "temperature" requires a device dedicated for presentation of haptic senses, and includes control information necessary for driving this device. For example, the control information contains control parameters associated with a force sense X-axis level value, a force sense Y-axis level value, a force sense Z-axis level value, a force sense presentation portion ID, a warm-cold level value, and a warm-cold presentation portion ID, as illustrated in a right part of the figure.

For haptic data associated with "force" and "temperature," lossless coding is adopted so as to transfer the control information configured as above with an update frequency approximately in a range shorter than dozens of hertz without losses.

Conventional technologies available for lossless coding include command transmission protocol, audio lossless coding, differential coding, and the like.

Command transmission protocol is a mechanism for low-frequency communication associated with commands such as "Audio/Video Remote Control Profile (AVRCP)" in Bluetooth (registered trademark). However, command transmission protocol is of a type different from protocol of "vibration" requiring streaming, and therefore is difficult to reliably synchronize with "vibration" in terms of time.

Audio lossless coding is highly efficient lossless coding such as "MPEG-4 Audio Lossless Coding." However, audio lossless coding utilizes auditory characteristics as prerequisites, and therefore is not suitable for coding of haptic data having different specifications such as a perception mechanism and a frequency band.

Differential coding is a type of entropy coding which focuses on a point that difference values are chiefly distributed in a range of small values on an assumption that changes of time-series data are small, i.e., a difference from previous data is small. Differential coding achieves highly efficient lossless coding by utilizing "Golomb-Rice coding" or the like or using linear prediction in combination with differential coding for audio signals (see PTL 1).

Meanwhile, haptic senses are distributed throughout a human body. It is therefore considered that a large number of portions of the body are designated as targets of haptic presentation. In a case where a large number of haptic presentation portions are designated, i.e., a large number of channels of haptic data are provided, a data volume may increase according to an increase in the number of channels if conventional differential coding is only applied individually.

This increase in the data volume may cause a critical situation of storage for recording data, instability of communication resulting from contraction of a communication band, or lowering of other information quality (e.g., reduction of an information volume of "vibration" or the like simultaneously transferred) in order to stabilize communication. Moreover, highly efficient coding using linear prediction residuals for audio signals as presented in PTL 1 is not suitable for haptic data.

Accordingly, the present technology uses multiplexed configuration coded data obtained by coding multiplexed configuration data indicating a multiplexed configuration of different types of data so as to achieve highly efficient coding of multiplexed data obtained by multiplexing different types of data.

### <2. Configurations>

### <System configuration>

FIG. 2 is a block diagram illustrating a configuration example of a data communication system according to the embodiment of the present technology.

A data communication system 1 in FIG. 2 is a system which transmits haptic coded data obtained by coding different types of haptic data and decodes the haptic coded data at a transmission destination to obtain haptic data.

The data communication system 1 includes a haptic sensor 10, storage 11, a cloud server 12, a data input device 13, a transmission device 14, a reception device 15, and a haptic display 16.

The haptic sensor 10 converts a physical quantity into time-series haptic data on the basis of a physical phenomenon associated with a haptic sense, such as vibration, force, and temperature, and outputs the haptic data to the data input device 13. For example, the haptic sensor 10 includes at least one sensor, such as a vibration sensor, an acceleration sensor, a pressure sensor, and a temperature sensor.

The storage 11 is a local recording device for recording acquired haptic data. The storage 11 outputs the recorded haptic data to the data input device 13.

The cloud server 12 is a recording device provided on the Internet to record acquired haptic data and various types of information. The cloud server 12 outputs (transmits) the recorded haptic data to the data input device 13 via the Internet.

The data input device 13 imports haptic data or various types of data attached thereto from at least one of the haptic sensor 10, the storage 11, and the cloud server 12, and outputs the imported data to the transmission device 14. The data input device 13 receives instruction information from a user in response to an operation input from the user through an input unit (not illustrated) or the like. The haptic data may be created by the data input device 13 in response to an operation from the user.

The transmission device 14 codes haptic data on the basis of haptic data and various types of data supplied from the data input device 13, and transmits the haptic coded data.

The reception device 15 receives haptic coded data transmitted from the transmission device 14, decodes the haptic coded data, and outputs the haptic data to the haptic display 16.

The haptic display 16 presents a haptic stimulus, such as vibration, force, and temperature, on the basis of haptic data supplied from the reception device 15.

### <Configuration of transmission device>

FIG. 3 is a block diagram illustrating a configuration example of the transmission device 14 in FIG. 2.

The transmission device 14 includes a control unit 31, a coding unit 32, a storage unit 33, an analysis unit 34, a communication unit 35, and a bus 36.

The control unit 31 imports haptic data supplied from the data input device 13 and instruction information issued from the user, outputs the imported data and information to each of the units within the transmission device 14, and controls each of the units.

The coding unit 32 codes haptic data on the basis of haptic data and user instruction information supplied from the control unit 31, to obtain haptic coded data. Note that details of the coding unit 32 will be described below. The coding unit 32 outputs the haptic coded data to the storage unit 33, the analysis unit 34, the communication unit 35, and others.

The storage unit 33 temporarily stores haptic data and user instruction information supplied from the control unit 31, and also serves as a working memory necessary for each of the units.

The analysis unit 34 analyzes haptic coded data. Note that details of the analysis unit 34 will be described below.

The communication unit 35 performs communication control for transmitting haptic coded data.

The bus 36 is a communication path through which control information and data are mutually transferred between the units.

Note that, while not illustrated in FIG. 3, a recording unit or the like for recording haptic coded data in a recording medium may be included in the transmission device 14. In this case, a reproduction unit for reproducing the recording medium is included in the reception device 15 in FIG. 4 referred to below, for example. In such a manner, haptic coded data can also be provided offline for the reception device 15 and the like.

### <Configuration of reception device>

FIG. 4 is a block diagram illustrating a configuration example of the reception device 15 in FIG. 2.

The reception device 15 includes a communication unit 41, a control unit 42, a storage unit 43, a decoding unit 44, a DAC (Digital Analog Converter) 45, and an amplifier 46.

The communication unit 41 performs communication control for receiving haptic coded data. The communication unit 41 outputs the received haptic coded data to the storage unit 43 or the decoding unit 44.

The control unit 42 controls each of the units within the reception device 15.

The storage unit 43 temporarily stores haptic coded data supplied from the communication unit 41, and also serves as a working memory necessary for each of the units.

The decoding unit 44 decodes haptic coded data supplied from the communication unit 41, to obtain haptic data. The decoding unit 44 outputs the obtained haptic data to the DAC 45. Note that details of the decoding unit 44 will be described below.

The DAC 45 is a device for converting digital signals to analog signals. The DAC 45 converts haptic data (digital signals) supplied from the decoding unit 44 into analog signals.

The amplifier 46 is a device for amplifying analog signals (e.g., power amplifier). The amplifier 46 amplifies analog signals supplied from the DAC 45, and outputs the amplified analog signals to the haptic display 16.

### <Configuration of coding unit>

FIG. 5 is a block diagram illustrating a configuration example of the coding unit 32 in FIG. 3.

Haptic data is input to the coding unit 32 for each of frames. Specifically, haptic data divided into units (haptic data frames) of fixed time-series samples is input to the coding unit 32 for each of the units of the haptic data.

The coding unit 32 includes a coding system selection unit 51, a lossy coding unit 52, a configuration data coding unit 53, a multiplexing unit 54, a lossless coding unit 55, and a connection unit 56.

The coding system selection unit 51 selects either lossy coding or lossless coding as a coding system adopted for haptic data of each channel, in accordance with instruction information issued from the user. At this time, the coding system selection unit 51 records an identifier (e.g., flag) for indicating the coding system in a header within a haptic coded data frame.

The lossy coding unit 52 performs highly efficient lossy coding for a haptic data frame on the basis of a coding system selected by the coding system selection unit 51, to generate a haptic lossy coded data frame. Examples of lossy coding herein include SBC (Subband Codec), MP3 (MPEG1 Audio Layer-III), and AAC (Advanced Audio Coding) adopted for ordinary audio coding.

The lossy coding unit 52 outputs the generated haptic lossy coded data frame to the connection unit 56.

For example, the configuration data coding unit 53 codes multiplexed configuration data indicating a multiplexed configuration of one or more types of haptic data supplied from the data input device 13 via the control unit 31, to generate multiplexed configuration coded data.

The multiplexed configuration data is data indicating a multiplexing order of control parameters included in control information constituting haptic data. For example, the multiplexed configuration data is written in any manner in a text format, such as "force sense value: 3, force sense presentation position: 5," and can be passed to the decoding side without change. Coding of the multiplexed configuration data refers to conversion of the multiplexed configuration data into data expressed in the form of a bit sequence for reduction of waste of data. Note that details of the multiplexed configuration coded data will be described below. The configuration data coding unit 53 outputs the generated multiplexed configuration coded data to the connection unit 56.

The multiplexing unit 54 multiplexes control parameters of haptic data corresponding to a target on the basis of the multiplexed configuration data described above to obtain a multiplexed haptic data frame. The multiplexing unit 54 outputs the generated multiplexed haptic data frame to the lossless coding unit 55.

The lossless coding unit 55 performs lossless coding for a multiplexed haptic data frame supplied from the multiplexing unit 54, to generate a haptic lossless coded data frame. Note that differential coding is employed as a lossless coding system, for example. The lossless coding unit 55 outputs the generated haptic lossless coded data frame to the connection unit 56.

The connection unit 56 generates a header, and connects the generated header, a haptic lossy coded data frame, multiplexed configuration coded data, and a haptic lossless coded data frame to one another to generate a haptic coded data frame. The haptic coded data frame is output to the storage unit 33, the analysis unit 34, the communication unit 35, and others.

### <Configuration of decoding unit>

FIG. 6 is a block diagram illustrating a configuration of the decoding unit 44 in FIG. 4.

Note that input to the decoding unit 44 is performed for each of haptic coded data frames.

The decoding unit 44 includes a disconnection unit 81, a decoding system determination unit 82, a lossy decoding unit 83, a configuration data decoding unit 84, a lossless decoding unit 85, and a demultiplexing unit 86.

The disconnection unit 81 analyzes a haptic coded data frame supplied from the communication unit 41, and decomposes the haptic coded data frame into a header, a haptic lossy coded data frame, multiplexed configuration coded data, and a haptic lossless coded data frame.

The disconnection unit 81 outputs the header, the haptic lossy coded data frame, and the haptic lossless coded data frame to the decoding system determination unit 82. The disconnection unit 81 outputs the multiplexed configuration coded data to the configuration data decoding unit 84.

The decoding system determination unit 82 reads an identifier (e.g., flag) of a header, and determines which of lossy coding and lossless coding has been used as a coding system for data of each of data frames. The decoding system determination unit 82 outputs a haptic lossy coded data frame to the lossy decoding unit 83. The decoding system determination unit 82 outputs a haptic lossless coded data frame to the lossless decoding unit 85.

The lossy decoding unit 83 performs lossy decoding for a haptic lossy coded data frame supplied from the disconnection unit 81, to obtain a haptic data frame.

The configuration data decoding unit 84 decodes multiplexed configuration coded data supplied from the disconnection unit 81, to obtain multiplexed configuration data. The configuration data decoding unit 84 outputs the multiplexed configuration data to the demultiplexing unit 86.

The lossless decoding unit 85 performs lossless decoding for a haptic lossless coded data frame supplied from the disconnection unit 81, to obtain a multiplexed haptic data frame.

The demultiplexing unit 86 demultiplexes a multiplexed haptic data frame on the basis of multiplexed configurations of respective haptic data (i.e., control parameters) indicated by multiplexed configuration data supplied from the configuration data decoding unit 84, to obtain respective control parameters.

### <3. Details>

### <Format example of configuration coded data>

FIG. 7 is a diagram illustrating a format example of configuration coded data.

Note that Syntax in the figure is a format standard written in a program code (C language). No. of bits is an information volume (number of bits) of corresponding constituent element. Mnemonic indicates a format of a corresponding constituent element.

In the figure, Configuration Information(nChannels, nParams) indicates configuration coded data having nChannels channels and nParams control parameters.

enableFlag is a flag indicating whether or not effective data (control parameter) is contained after this flag. No. of bits of enable flag is 1, while Mnemonic of enableFlag is bslbf. Note that bslbf is a bit sequence and indicates that the left bit corresponds to the head.

In a case where enableFlag has a value of 0, it is indicated that no effective data is contained after enableFlag. In a case where enableFlag has a value of 1, it is indicated that effective data is contained after enableFlag.

In a case of a change of an initial stage or a configuration of communication, the value of enableFlag is set to 1 to notify the decoding side of this change. In other cases, the value of enableFlag is set to 0 to save a communication capacity.

paramId[ich] [idx] indicates an ID number of an idx-th control parameter in an ich-th channel. No. of bits of paramId[ich] [idx] is 4, while Mnemonic of paramId[ich] [idx] is uimsbf. Note that uimsbf is an unsigned integer and indicates that the most significant bit corresponds to the head.

bitLength[ich][idx] indicates a bit length of the idx-th control parameter in the ich-th channel.

Any order of control parameters in multiplexed haptic data can be reproduced by sequentially recording control parameter sets each constituted by paramId[ich][idx] and bitLength[ich][idx] described above from a high-order control parameter in the configuration data.

Note that at least any one of paramId[ich][idx] and bitLength[ich][idx] is only required to be included. Specifically, only either the element or the bit length (information volume) can be fixed as a standard, while the other can be transferred. For example, in a case where the information volume is specified as "1 bit, 3 bits, and 5 bits in this order from the head," only the element is required to be transferred without a necessity of transfer of the information volume.

### <Process by coding unit>

FIG. 8 is a flowchart illustrating a process performed by the coding unit 32 in FIG. 5.

Note that haptic data divided into units (haptic data frames) of fixed time-series samples is input to the coding unit 32 for each of the units of the haptic data.

In step S11, the coding system selection unit 51 selects one channel, and determines whether or not a haptic data frame of the selected channel is a lossless coding target. In a case of determination in step S11 that the haptic data frame of the selected channel is not a lossless coding target, the process proceeds to step S12.

In step S12, the lossy coding unit 52 performs lossy coding for the haptic data frame of the corresponding channel to generate a haptic lossy coded data frame. The lossy coding unit 52 outputs the generated haptic lossy coded data frame to the connection unit 56. Thereafter, the process proceeds to step S13.

In a case of determination in step S11 that the haptic data frame of the selected channel is a lossless coding target, the process proceeds to step S13.

In step S13, the coding system selection unit 51 determines whether or not determination has been completed for all of the channels. In a case of determination that determination has not been completed for all of the channels yet, the process returns to step S11 to repeat processing following this step.

In a case of determination in step S13 that determination has been completed for all of the channels, the process proceeds to step S14.

In step S14, the configuration data coding unit 53 codes multiplexed configuration data indicating a multiplexed configuration of one or more types of haptic data supplied from the data input device 13 via the control unit 31, for example, on the basis of the format of the configuration coded data in FIG. 7 to generate multiplexed configuration coded data.

In step S15, the multiplexing unit 54 multiplexes respective control parameters corresponding to targets on the basis of the multiplexed configuration data described above to obtain a multiplexed haptic data frame. The multiplexing unit 54 outputs the multiplexed haptic data frame to the lossless coding unit 55.

In step S16, the lossless coding unit 55 performs lossless coding for multiplexed haptic data frame supplied from the multiplexing unit 54, to generate a haptic lossless coded data frame. The lossless coding unit 55 outputs the generated haptic lossless coded data frame to the connection unit 56.

In step S17, the connection unit 56 connects the header, the haptic lossy coded data frame, the multiplexed configuration coded data, and the haptic lossless coded data frame to one another to generate a haptic coded data frame. Note that the header is generated by the connection unit 56.

The generated haptic coded data frame is transmitted to the reception device 15 via the communication unit 35. After completion of step S17, the process ends.

### <Configuration of data frame>

FIG. 9 is a diagram illustrating a concept of a configuration example of a data frame.

The haptic data frame includes a haptic data frame CH1 (vibration) and a multiplexed haptic data frame (CH2 to CH4).

The multiplexed haptic data frame includes a haptic data frame (control parameter) CH2 (force 1), a haptic data frame (control parameter) CH3 (force 2), and a haptic data frame (control parameter) CH3 (temperature).

A haptic coded data frame is generated by the haptic data frame being coded.

The haptic coded data frame includes a header, a haptic lossy coded data frame (CH1), multiplexed configuration coded data (CH2 to CH4), and a haptic lossless coded data frame (CH2 to CH4).

### <Example of multiplexed configuration>

FIG. 10 is a diagram illustrating an example of a multiplexed configuration.

FIG. 10 illustrates a haptic lossless data frame generated by multiplexing a haptic lossless data frame including control parameters of "force sense level value: 252," "force sense presentation position ID: 2," "warm-cold level value: 1," and "warm-cold presentation position ID: 0" with use of a multiplexing method 1 (worst case) and a multiplexing method 2 (optimized case according to the present technology).

The multiplexing method 1 is a method which forms a multiplexed configuration on the basis of at least either an increase in an update frequency of each data constituting the multiplexed configuration or an increase in a change of each data at the time of update from a lower order of bits to a higher order.

In the case of the multiplexing method 1, the multiplexed configuration includes 1-bit unused region, an 8-bit force sense level value, a 2-bit force sense presentation position ID, a 3-bit warm-cold level value, and a 2-bit warm-cold presentation position ID from the high order side of the bits.

In this case, actual data of the haptic lossless data frame at a time t1 includes 0b(0), 11111100b(252), 10b(2), 001b(1), and 00b(0) = 0x7E44. Actual data of the haptic lossless data frame at a time t2 includes 0b(0), 11111101b(253), 10b(2), 001b(1), and 00b(0) = 0x7EC4. Accordingly, a difference in actual data of the haptic lossless data frame between the time t1 and the time t2 is 128.

The multiplexing method 2 is a method which forms a multiplexed configuration on the basis of at least either a decrease in an update frequency of each data constituting the multiplexed configuration or a decrease in a change of each data at the time of update from a lower order of bits to a higher order.

In the case of the multiplexing method 2, the multiplexed configuration includes a 1-bit unused region, a 2-bit warm-cold presentation position ID, a 3-bit warm-cold level value, a 2-bit force sense presentation position ID, and an 8-bit force sense level value from the high order side of the bits.

In this case, actual data of the haptic lossless data frame at the time t1 includes 0b(0), 00b(0), 001b(1), 10b(2), and 11111100b(252) = 0x6FC. Actual data of the haptic lossless data frame at the time t2 includes 0b(0), 00b(0), 001b(1), 10b(2), and 11111101b(253) = 0x06FD. Accordingly, a difference in actual data of the haptic lossless data frame between the time t1 and the time t2 is 1.

It is important herein for the multiplexed configuration that the multiplexed configuration can offer the highest possible coding efficiency at the time of multiplexing. Specifically, as can be understood from the multiplexing method 2 described above with reference to FIG. 10, the order of the control parameters in the multiplexed configuration is determined such that information entropy of differential coding used in the lossless coding is minimized (a probability of occurrence of a value difference close to zero increases).

### <Multiplexed configuration determining method>

FIG. 11 is a diagram illustrating a screen example of a GUI application for determining the multiplexed configuration.

Various methods are available for determining the multiplexed configuration. For example, a determining method based on an intention of the user, a determining method based on downloaded data from the cloud server 12, a determining method based on statistical analysis and machine learning, and others are available as the multiplexed configuration determining method.

For example, some of the multiple multiplexed configuration determining methods may be incorporated into the configuration data coding unit 53, and the multiplexed configuration determining method to be used may be selected by the user beforehand with use of the data input device 13 before a start of communication.

Selection of the multiplexed configuration method with use of the data input device 13 may be achieved by input of characters or numerals through a keyboard on a command line or input through a screen of a GUI application illustrated in FIG. 11.

FIG. 11 illustrates a CONFIGURATION SETTING screen 111 of the GUI application.

The CONFIGURATION SETTING screen 111 includes a selector switch 121, a MANUAL SETTING screen 122, an AUTO SETTING screen 123, a SAVE button 124, and a LOAD button 125.

The selector switch 121 is a switch for switching the SETTING screen to be used between the MANUAL SETTING screen 122 and the AUTO SETTING screen 123 to be used. When the selector switch 121 is shifted to the left, a manual operation, i.e., an operation of the MANUAL SETTING screen 122, is activated. When the selector switch 121 is shifted to the right, an automatic operation, i.e., an operation of the AUTO SETTING screen 123, is activated.

The MANUAL SETTING screen 122 includes a TGT (multiplexing results) setting portion and control parameter setting portions for respective channels of CH1 (vibration control channel), CH2 (force sense control channel), and CH3 (temperature control channel).

The respective control parameters are designated with use of a cursor at the control parameter setting portions of the respective channels corresponding to multiplexing targets among the respective channels CH1 to CH3, and the designated control parameters are reflected in a data configuration of the TGT (multiplexing results) setting portion. In this manner, the multiplexed configuration can manually be set.

Note that the set multiplexed configuration can be converted into a file (multiplexed configuration data file) by pressing the SAVE button 124 to store the file. In this case, the file can be read on a different occasion by pressing the LOAD button 125 to reuse the stored settings.

The AUTO SETTING screen 123 includes a DL button 141 and a URL input portion 142 of SERVER DATA, an OPEN button 143 and a file input portion 144 of MACHINE LEARNING DATA, and a switch 145 of ADAPTIVE CONFIGURATION.

The DL button 141 of SERVER DATA is a button pressed when multiplexed configuration data registered in the cloud server 12, for example, is downloaded via a network such as the Internet.

The URL input portion 142 is an input portion which receives input of a URL of the cloud server 12 where multiplexed configuration data desired to be downloaded is registered.

The OPEN button 143 of MACHINE LEARNING DATA is a button for reading a statistical learning file associated with a previous multiplexed configuration.

The file input portion 144 is an input portion which receives input of a statistical learning file associated with a previous multiplexed configuration.

For example, the switch 145 of ADAPTIVE CONFIGURATION is a switch for setting on or off of a function of automatically achieving an adaptive configuration change (i.e., change of haptic data to be used) in response to a change of a device configuration associated with transmission and reception of haptic data (at least any one of the transmission side and the reception side).

The multiplexed configuration determining method is selected by the user through the CONFIGURATION SETTING screen 111 configured as above, and multiplexed configuration data indicating a multiplexed configuration determined by the selected determining method is generated.

An example of the CONFIGURATION SETTING screen 111 in FIG. 11 will hereinafter be described in detail. However, a user interface to be used is not limited to the CONFIGURATION SETTING screen 111.

### (Determining method based on intention of user)

In a case where the user intentionally determines the configuration on the basis of an experience or an intuition, the MANUAL SETTING screen 122 in FIG. 11 is used, for example. The respective control parameters of "CH2 (force sense control channel)" and "CH3 (temperature control channel)" corresponding to multiplexing targets among the respective channels of "CH1" to "CH3" can be designated one by one in the MANUAL SETTING screen 122 with use of the cursor and reflected in the data configuration of "TGT (multiplexing results)" simultaneously with the designation to determine the multiplexed configuration.

### (Determination based on downloaded data from server)

An individual or a group supporting haptic transfer, a company managing haptic transfer as a service, or the like determines beforehand an optimal multiplexed configuration of control parameters of a device presenting haptic senses, and discloses multiplexed configuration data to users desiring to use the multiplexed configuration, via the cloud server 12 or the like, for example. Each of the users can download the multiplexed configuration data from the cloud server 12 via the Internet to acquire the multiplexed configuration. Note that the cloud server 12 used herein is only an example. Other servers may also be used.

For example, the multiplexed configuration data can be downloaded from the cloud server 12 by inputting a URL of the multiplexed configuration data into the URL input portion 142 of the AUTO SETTING screen 123 in FIG. 11 and pressing the DL button 141.

### (Determination based on statistical analysis and machine learning)

The multiplexed configuration can be obtained by at least any one of statistical analysis and machine learning (hereinafter referred to as a statistical/learning process) based on a result of recording of coding efficiency achieved with a multiplexed configuration previously adopted by a terminal of the user, and can be used as a multiplexed configuration optimal at the moment.

For example, a statistical analysis and machine learning data file is input into the file input portion 144 of the AUTO SETTING screen 123 in FIG. 11, and the OPEN button 143 is pressed. In this manner, optimal multiplexed configuration data at the moment becomes available, and future coding efficiency information can simultaneously be added.

Note that the statistical/learning process may be performed either during transfer of haptic data or after a transfer end of haptic data. In addition, the statistical/learning process is carried out by the analysis unit 34 in FIG. 3.

For example, the statistical/learning process may be practiced by such a method which records a large number of sets each constituted by multiplexed configuration data and average coding efficiency from a start to an end of communication under an application used by the user and in an associated situation and then adopts multiplexed configuration data achieving the maximum average coding efficiency as the optimal multiplexed configuration data at the moment.

### <Handling of device configuration change>

The multiplexed configuration is determined by the determining methods described above. When any situation change occurs in the middle of communication, the multiplexed configuration may be required to be changed.

Examples of the situation change include such a case where the user intentionally changes or removes a device for presenting haptic senses, for example, for reasons such as a breakdown of the device and deterioration of a wireless communication path. In this case, the device configuration changes, so that a change of haptic data to be used and a change of multiplexed configuration coded data are also required.

Accordingly, pieces of multiplexed configuration coded data sufficient for combinations of the configurations of the device are recorded beforehand. In this manner, appropriate multiplexed configuration coded data can immediately be transmitted without a necessity of interruption of communication after the device configuration change.

As described above, an optional function which automatically applies an adaptive configuration change to a device configuration change is provided, and the ADAPTIVE CONFIGURATION switch 145 of the AUTO SETTING screen 123 in FIG. 11 is turned on, for example. In this manner, a configuration change can automatically be achieved.

### <Process by decoding unit>

FIG. 12 is a flowchart illustrating a process performed by the decoding unit 44 in FIG. 6.

Note that input to the decoding unit 44 is performed for each of haptic coded data frames.

In step S111, the disconnection unit 81 analyzes and disconnects an input haptic coded data frame, and decomposes the haptic coded data frame into a header, a haptic lossy coded data frame, multiplexed configuration coded data, and a haptic lossless coded data frame. Note that the following process is performed for each of data blocks (coded data frames).

In step S112, the decoding system determination unit 82 determines whether or not the current data block is a lossless coding target, on the basis of an identifier read from the header. In a case of determination in step S112 that the data block is not a lossless coding target, the process proceeds to step S113.

In step S113, the lossy decoding unit 83 decodes a haptic lossy coded data frame to obtain a haptic data frame. After completion of step S113, the process proceeds to step S117.

Meanwhile, in a case of determination in step S112 that the data block is a lossless coding target, the process proceeds to step S114.

In step S114, the configuration data decoding unit 84 decodes multiplexed configuration coded data supplied from the disconnection unit 81, to obtain multiplexed configuration data. The configuration data decoding unit 84 outputs the multiplexed configuration data to the demultiplexing unit 86.

In step S115, the lossless decoding unit 85 decodes haptic lossless coded data supplied from the disconnection unit 81, to obtain a multiplexed haptic data frame.

In step S116, the demultiplexing unit 86 demultiplexes the multiplexed haptic data frame on the basis of multiplexed configurations of respective haptic data (control parameters) indicated by the multiplexed configuration data and supplied from the configuration data decoding unit 84, to obtain respective control parameters.

In step S117, the decoding system determination unit 82 determines whether or not processing has been completed for all of the data blocks. In a case of determination in step S117 that processing has not been completed for all of the data blocks yet, the process returns to step S112 to repeat processing following this step.

In a case of determination in step S117 that processing has been completed for all of the data blocks, the process ends.

### <4. Others>

### <Modifications>

While vibration, force, and temperature have been presented as examples of the physical phenomenon associated with haptic senses in the above description, the physical phenomenon associated with haptic senses includes wind, pain, presentation portions, positions, directions, time, displacement, speed, acceleration, angles, voltage, current, and the like in addition to the foregoing examples.

Note that, while described in the present embodiment has been the example of lossy coding of haptic data for vibration, haptic data for vibration may be data including control information like haptic data for force, and may be losslessly coded.

Further, while the present technology is chiefly applied to lossless coding as described above, the present technology may be applied to lossy coding. Note that algorithms for lossy coding include such an algorithm which uses a prediction model for predicting future data from a previous data sequence, such as linear prediction, and quantizes and codes a difference between data before coding and the prediction model on the basis of the prediction model. Accordingly, target data for multiple channel lossy coding can be multiplexed with use of the present technology, and a difference of multiplexed data can subsequently be quantized and coded.

### <Advantageous effects of present technology>

As described above, the present technology acquires multiplexed configuration data indicating a multiplexed configuration of different types of haptic data, decodes multiplexed coded data obtained by coding multiplexed data obtained by multiplexing the different types of haptic data on the basis of the multiplexed configuration data, to obtain the multiplexed data, and demultiplexes the multiplexed data on the basis of the multiplexed configuration data.

In this case, multiplexed data can more efficiently be coded than in a case of individual coding of a haptic data (control parameter) group. Accordingly, storage capacity saving at the time of recording of haptic data (control parameters) and improvement of stability of narrow-band communication such as near field communication are expected to be achievable.

Moreover, for coding or decoding multiplexed data obtained by multiplexing different types of haptic data, multiplexed configuration coded data which is generated by coding multiplexed configuration data indicating a multiplexed configuration of different types of data is used.

Accordingly, waste of data can be reduced.

### <Configuration example of computer>

A series of processes described above can be executed either by hardware or by software. In a case where the series of processes are executed by software, a program constituting the software is installed in a computer incorporated in dedicated hardware, a general-purpose personal computer, or the like from a program recording medium.

FIG. 13 is a block diagram illustrating a hardware configuration example of a computer which executes the series of processes described above under a program.

A CPU (Central Processing Unit) 301, a ROM (Read Only Memory) 302, and a RAM (Random Access Memory) 303 are connected to each other via a bus 304.

An input/output interface 305 is further connected to the bus 304. An input unit 306 including a keyboard, a mouse, and others and an output unit 307 including a display, a speaker, and others are connected to the input/output interface 305. Moreover, a storage unit 308 including a hard disk, a non-volatile memory, and others, a communication unit 309 including a network interface and others, and a drive 310 driving a removable medium 311 are connected to the input/output interface 305.

According to the computer configured as described above, for example, the CPU 301 loads a program stored in the storage unit 308 into the RAM 303 via the input/output interface 305 and the bus 304, and executes the loaded program to perform the series of processes described above.

For example, the program executed by the CPU 301 is recorded in the removable medium 311, or provided via a wired or wireless transfer medium such as a local area network, the Internet, and digital broadcasting, and then installed in the storage unit 308.

Note that the program executed by the computer may be a program where processes are performed in an order described in the present description in time series, or may be a program where processes are performed in parallel or at necessary timing such as an occasion of a call.

Note that a system in the present description refers to a set of multiple constituent elements (devices, modules (parts), etc.). A set of constituent elements are regarded as a system regardless of whether or not all of the constituent elements are contained in an identical housing. Accordingly, multiple devices accommodated in different housings and connected to each other via a network and one device which contains multiple modules in one housing are both regarded as a system.

Moreover, advantageous effects to be offered are not limited to the advantageous effects described in the present description only by way of example. Other advantageous effects may further be produced.

Embodiments according to the present technology are not limited to the embodiment described above. Various modifications can be made within a scope not departing from the concept of the present technology.

For example, the present technology can have a configuration of cloud computing where one function is shared and processed by multiple devices in cooperation with each other via a network.

In addition, the steps described in the flowcharts described above can be executed by one device, or shared and executed by multiple devices.

Moreover, in a case where one step includes multiple processes, the multiple processes included in the one step can be executed by one device, or shared and executed by multiple devices.

The present technology can also be configured as follows.
(1) A decoding device including:
   an acquisition unit that acquires multiplexed configuration data indicating a multiplexed configuration of different types of data;
   a data decoding unit that decodes multiplexed coded data obtained by coding multiplexed data obtained by multiplexing the different types of data on the basis of the multiplexed configuration data, to obtain the multiplexed data; and
   a demultiplexing unit that demultiplexes the multiplexed data on the basis of the multiplexed configuration data.
(2) The decoding device according to (1) above, in which
   the acquisition unit acquires the multiplexed configuration data by decoding multiplexed configuration coded data obtained by coding the multiplexed configuration data.
(3) The decoding device according to (2) above, in which
   the multiplexed configuration coded data is generated on the basis of at least either a decrease in an update frequency of the different types of data constituting the multiplexed data or a decrease in a change at a time of updates of the different types of data from a lower order of bits to a higher order.
(4) The decoding device according to (3) above, in which
   the multiplexed configuration coded data includes at least one of an element that specifies the different types of data and a data volume of the different types of data, and an order of the at least one of the element and the data volume indicates an order of the different types of data in the multiplexed data.
(5) The decoding device according to any one of (1) to (4) above, in which
   the multiplexed coded data is losslessly coded, and
   the data decoding unit losslessly decodes the multiplexed coded data.
(6) The decoding device according to any one of (1) to (5) above, in which
   the different types of data include control information for presenting a haptic sense.
(7) The decoding device according to (6) above, in which
   the haptic sense includes at least one of force and temperature.
(8) A decoding method including:
   by a decoding device,
   acquiring multiplexed configuration data indicating a multiplexed configuration of different types of data;
   decoding multiplexed coded data obtained by coding multiplexed data obtained by multiplexing the different types of data on the basis of the multiplexed configuration data, to obtain the multiplexed data; and
   demultiplexing the multiplexed data on the basis of the multiplexed configuration data.
(9) A coding device including:
   a data coding unit that codes multiplexed data obtained by multiplexing different types of data on the basis of multiplexed configuration data indicating a multiplexed configuration of the different types of data to generate multiplexed coded data; and
   an output unit that outputs the multiplexed configuration data and the multiplexed coded data to an outside.
(10) The coding device according to (9) above, further including:
   a configuration coding unit that codes the multiplexed configuration data to generate multiplexed configuration coded data, in which
   the output unit outputs the multiplexed configuration coded data and the multiplexed coded data.
(11) The coding device according to (10) above, in which
   the configuration coding unit generates the multiplexed configuration coded data on the basis of at least either a decrease in an update frequency of the different types of data constituting the multiplexed data or a decrease in a change at a time of updates of the different types of data from a lower order of bits to a higher order.
(12) The coding device according to (10) above, in which
   the multiplexed configuration coded data includes at least one of an element that specifies the different types of data and a data volume of the different types of data, and an order of the at least one of the element and the data volume indicates an order of the different types of data in the multiplexed data.
(13) The coding device according to any one of (9) to (12) above, in which
   the multiplexed configuration data is generated on the basis of at least one of an operation performed by a user, the multiplexed configuration data that is existing, statistical analysis of a previous coding result, and a result of machine learning.
(14) The coding device according to any one of (9) to (13) above, further including:
   a multiplexing unit that multiplexes the different types of data on the basis of the multiplexed configuration data to obtain the multiplexed data.
(15) The coding device according to (9) above, in which
   the data coding unit losslessly codes the multiplexed data.
(16) The coding device according to (15) above, further including:
   a lossy coding unit that codes different data of a type other than those of the different types of data in a lossy manner to generate lossy coded data, in which
   the output unit outputs the multiplexed configuration coded data, the multiplexed coded data, and the lossy coded data.
(17) The coding device according to any one of (9) to (16) above, in which
   the different types of data include control information for presenting a haptic sense.
(18) The coding device according to (17) above, in which
   the haptic sense includes at least one of force and temperature.
(19) A coding method including:
   by a coding device,
   coding multiplexed data obtained by multiplexing different types of data on the basis of multiplexed configuration data indicating a multiplexed configuration of the different types of data to generate multiplexed coded data; and
   outputting the multiplexed configuration data and the multiplexed coded data to an outside.

### [Reference Signs List]

1: Data communication system
10: Haptic sensor
11: Storage
12: Cloud
13: Data input device
14: Transmission device
15: Reception device
16: Haptic display
31: Control unit
32: Coding unit
33: Storage unit
34: Analysis unit
35: Communication unit
36: Bus
41: Communication unit
42: Control unit
43: Storage unit
44: Decoding unit
45: DAC
46: Amplifier
51: Coding system selection unit
52: Lossy coding unit
53: Configuration data coding unit
54: Multiplexing unit
55: Lossless coding unit
56: Connection unit
81: Disconnection unit
82: Decoding system determination unit
83: Lossy decoding unit
84: Configuration data decoding unit
85: Lossless decoding unit
86: Demultiplexing unit

## Claims

1. A decoding device comprising:
an acquisition unit that acquires multiplexed configuration data indicating a multiplexed configuration of different types of data;
a data decoding unit that decodes multiplexed coded data obtained by coding multiplexed data obtained by multiplexing the different types of data on a basis of the multiplexed configuration data, to obtain the multiplexed data; and
a demultiplexing unit that demultiplexes the multiplexed data on the basis of the multiplexed configuration data.

2. The decoding device according to claim 1, wherein
the acquisition unit acquires the multiplexed configuration data by decoding multiplexed configuration coded data obtained by coding the multiplexed configuration data.

3. The decoding device according to claim 2, wherein
the multiplexed configuration coded data is generated on a basis of at least either a decrease in an update frequency of the different types of data constituting the multiplexed data or a decrease in a change at a time of updates of the different types of data from a lower order of bits to a higher order.

4. The decoding device according to claim 3, wherein
the multiplexed configuration coded data includes at least one of an element that specifies the different types of data and a data volume of the different types of data, and an order of the at least one of the element and the data volume indicates an order of the different types of data in the multiplexed data.

5. The decoding device according to claim 1, wherein
the multiplexed coded data is losslessly coded, and
the data decoding unit losslessly decodes the multiplexed coded data.

6. The decoding device according to claim 1, wherein
the different types of data include control information for presenting a haptic sense.

7. The decoding device according to claim 6, wherein
the haptic sense includes at least one of force and temperature.

8. A decoding method comprising:
by a decoding device,
acquiring multiplexed configuration data indicating a multiplexed configuration of different types of data;
decoding multiplexed coded data obtained by coding multiplexed data obtained by multiplexing the different types of data on a basis of the multiplexed configuration data, to obtain the multiplexed data; and
demultiplexing the multiplexed data on a basis of the multiplexed configuration data.

9. A coding device comprising:
a data coding unit that codes multiplexed data obtained by multiplexing different types of data on a basis of multiplexed configuration data indicating a multiplexed configuration of the different types of data to generate multiplexed coded data; and
an output unit that outputs the multiplexed configuration data and the multiplexed coded data to an outside.

10. The coding device according to claim 9, further comprising:
a configuration coding unit that codes the multiplexed configuration data to generate multiplexed configuration coded data, wherein
the output unit outputs the multiplexed configuration coded data and the multiplexed coded data.

11. The coding device according to claim 10, wherein
the configuration coding unit generates the multiplexed configuration coded data on a basis of at least either a decrease in an update frequency of the different types of data constituting the multiplexed data or a decrease in a change at a time of updates of the different types of data from a lower order of bits to a higher order.

12. The coding device according to claim 11, wherein
the multiplexed configuration coded data includes at least one of an element that specifies the different types of data and a data volume of the different types of data, and an order of the at least one of the element and the data volume indicates an order of the different types of data in the multiplexed data.

13. The coding device according to claim 9, wherein
the multiplexed configuration data is generated on a basis of at least one of an operation performed by a user, the multiplexed configuration data that is existing, statistical analysis of a previous coding result, and a result of machine learning.

14. The coding device according to claim 9, further comprising:
a multiplexing unit that multiplexes the different types of data on the basis of the multiplexed configuration data to obtain the multiplexed data.

15. The coding device according to claim 9, wherein
the data coding unit losslessly codes the multiplexed data.

16. The coding device according to claim 15, further comprising:
a lossy coding unit that codes different data of a type other than those of the different types of data in a lossy manner to generate lossy coded data, wherein
the output unit outputs the multiplexed configuration coded data, the multiplexed coded data, and the lossy coded data.

17. The coding device according to claim 9, wherein
the different types of data include control information for presenting a haptic sense.

18. The coding device according to claim 17, wherein
the haptic sense includes at least one of force and temperature.

19. A coding method comprising:
by a coding device,
coding multiplexed data obtained by multiplexing different types of data on a basis of multiplexed configuration data indicating a multiplexed configuration of the different types of data to generate multiplexed coded data; and
outputting the multiplexed configuration data and the multiplexed coded data to an outside.
